(19) Europäisches Patentamt
European Patent Office
Office européen des brevets

(11) **EP 4 264 669 B1**

(12) **FASCICULE DE BREVET EUROPEEN**

(45) Date de publication et mention
de la délivrance du brevet:
**27.11.2024 Bulletin 2024/48**

(21) Numéro de dépôt: **21851681.3**

(22) Date de dépôt: **15.12.2021**

(51) Classification Internationale des Brevets (IPC):
*H01L 27/146* *(2006.01)*

(52) Classification Coopérative des Brevets (CPC):
**H01L 27/1462; H01L 27/14625; H01L 27/14627;
H01L 27/1467;** H01L 27/14629; H01L 27/14685;
H01L 27/14694

(86) Numéro de dépôt international:
**PCT/FR2021/052347**

(87) Numéro de publication internationale:
**WO 2022/129791 (23.06.2022 Gazette 2022/25)**

(54) **PHOTODÉTECTEUR MULTISPECTRAL INFRAROUGE**

MULTISPEKTRALER INFRAROT-FOTODETEKTOR

MULTISPECTRAL INFRARED PHOTODETECTOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **17.12.2020 FR 2013324**

(43) Date de publication de la demande:
**25.10.2023 Bulletin 2023/43**

(73) Titulaire: **Commissariat à l'Energie Atomique et
aux Energies
Alternatives
75015 Paris (FR)**

(72) Inventeur: **BADANO, Giacomo
38054 Grenoble Cedex 9 (FR)**

(74) Mandataire: **Brevalex
56, Boulevard de l'Embouchure
B.P. 27519
31075 Toulouse Cedex 2 (FR)**

(56) Documents cités:
**US-A1- 2017 234 726     US-B2- 9 972 727**

EP 4 264 669 B1

**Description**

**DOMAINE TECHNIQUE**

L'invention se rapporte à un dispositif de photo-détection multispectrale dans l'infrarouge, c'est-à-dire un dispositif de détection de photons, sensible dans l'infrarouge, et comportant au moins deux types de pixels qui diffèrent par leurs plages respectives de sensibilité spectrale. En utilisation, un tel dispositif est couplé à un refroidisseur, pour abaisser sa température aux températures cryogéniques.

**ÉTAT DE LA TECHNIQUE ANTÉRIEURE**

Un dispositif de photo-détection multi-spectrale infrarouge comporte classiquement une matrice de photodiodes intégrée dans un substrat semi-conducteur, et des filtres spectraux pour filtrer la lumière infrarouge arrivant sur les photodiodes. Le substrat semi-conducteur, nommé ici couche active, repose avantageusement sur un substrat de support (substrat de croissance après amincissement) qui confère à l'ensemble la rigidité mécanique souhaitée.

L'invention se rapporte plus particulièrement à un dispositif de photo-détection dit « hybridé », c'est-à-dire incorporant un circuit de lecture des photodiodes qui est situé sous la matrice de photodiodes. Le circuit de lecture est connecté électriquement à chacune des photodiodes de la matrice de photodiodes, généralement par des billes métalliques.

Un objectif de la présente invention est de proposer un dispositif de photo-détection multi-spectrale dans l'infrarouge, hybridé, et offrant des performances améliorées en termes de reconstruction de couleurs, en comparaison avec l'art antérieur.

Le document US 9 972 727 B2 décrit un dispositif de photo-détection multi-spectrale infrarouge selon l'art antérieur.

**EXPOSÉ DE L'INVENTION**

Cet objectif est atteint avec un dispositif pour mettre en oeuvre une photo-détection multi-spectrale dans l'infrarouge, qui comporte un étage de photo-détection et un étage de filtrage, superposés l'un au-dessus de l'autre le long d'un axe nommé axe optique, dans lequel :

- l'étage de photo-détection comporte un circuit de lecture, une couche active en matériau semi-conducteur, incorporant une matrice de photodiodes, et un substrat de support, superposés dans cet ordre le long de l'axe optique, et avec le circuit de lecture connecté électriquement aux photodiodes de la matrice de photodiodes ;
- l'étage de filtrage comprend une matrice de zones de filtrage qui est constituée de zone de filtrage d'au moins deux types, parmi lesquelles des zones de filtrage d'un premier type, formées chacune d'un filtre interférentiel et aptes chacune à transmettre les longueurs d'onde d'une première bande spectrale et à bloquer les longueurs d'onde d'une deuxième bande spectrale, et des zones de filtrage d'un deuxième type, aptes chacune à transmettre une partie au moins des longueurs d'onde de la deuxième bande spectrale.

Le substrat de support peut correspondre à la partie résiduelle d'un substrat de croissance de la couche active, après amincissement.

Un filtre interférentiel désigne un filtre dans lequel la séparation des longueurs d'onde est basée sur la transmission de la lumière dans une certaine plage de longueurs d'onde et la réflexion de la lumière dans une autre plage de longueurs d'onde (par opposition à des filtres absorbants constitués par exemple d'une résine colorée dans le visible).

Selon l'invention, le dispositif de photo-détection comporte en outre :

- une couche de colle, qui s'étend entre l'étage de photo-détection et l'étage de filtrage, avec, dans l'étage de photo-détection, le substrat de support situé du côté de la couche de colle ; et
- un revêtement antireflet, qui s'étend entre la couche de colle et le substrat de support, et qui est configuré pour réduire des réflexions internes dans l'infrarouge.

L'étage de photo-détection, incluant la matrice de photodiodes et son circuit de lecture, forme un composant hybridé.

De manière avantageuse, à la fabrication, la couche active est formée sur un substrat de croissance, puis hybridée avec lui sur le circuit de lecture. Ensuite, le substrat de croissance est aminci, pour former le substrat de support. Ce procédé permet d'avoir une surface la plus plane possible au niveau du substrat de support, du côté opposé à la couche active. La planarisation ne peut cependant être parfaite. En outre, en utilisation, le composant hybridé est porté à très basses températures, ce qui exacerbe le défaut de planéité résiduel (en raison notamment de la différence de coefficient de dilatation thermique entre le matériau du circuit de lecture et le matériau de la couche active).

Afin notamment de limiter les risques d'endommagement de la matrice de photodiodes, l'étage de filtrage est réalisé de préférence à part, puis rapporté par collage sur l'étage de photo-détection. Il existe donc une couche de colle, entre l'étage de filtrage et l'étage de photo-détection, plus particulièrement entre l'étage de filtrage et le substrat de support. Cette couche de colle présente avantageusement une épaisseur variable dans l'espace, pour compenser le défaut de planéité du substrat de support.

On définit, dans le dispositif de photo-détection, des pixels qui comportent chacun une et unique photodiode de la matrice de photodiodes. Afin de réduire une diaphonie entre les pixels du dispositif de photo-détection, il est nécessaire de rapprocher autant que possible l'étage de filtrage et la matrice de photodiodes. Il est également nécessaire de conserver une certaine épaisseur de substrat de support, pour garantir la bonne stabilité mécanique du dispositif selon l'invention. Le rapprochement entre l'étage de filtrage et la matrice de photodiodes passe alors par une couche de colle la plus fine possible.

Les inventeurs ont alors fait la remarque suivante : lorsque la couche de colle est en contact physique direct avec le substrat de support, une interface entre la couche de colle et le substrat de support forme une surface réfléchissante aux longueurs d'onde infrarouges, notamment aux longueurs d'onde détectées par la matrice de photodiodes. En outre, les zones de filtrage de la matrice de zones de filtrage sont également susceptibles de réfléchir la lumière à l'intérieur du dispositif de photo-détection, notamment les zones de filtrages formées chacune par un filtre interférentiel. Il se forme ainsi une cavité optique, au-dessus de l'étage de photo-détection, entre le substrat de support et les filtres interférentiels de la matrice de zones de filtrage. Dans chaque pixel du dispositif de photo-détection, la cavité optique est excitée localement, aux longueurs d'onde transmises par le filtre interférentiel appartenant audit pixel (le filtre n'est pas parfait, et réfléchit un peu à ces longueurs d'onde). Dans chaque pixel du dispositif de photo-détection, la cavité optique est excitée par de la lumière transmise au travers de la zone de filtrage appartenant audit pixel. La cavité optique est excitée également par de la lumière bloquée par la zone de filtrage d'un pixel voisin, et parvenant dans le pixel considéré du fait par exemple de phénomènes de diffraction. Cette lumière, bloquée, par le pixel voisin, est pour une large part réfléchie par le filtre interférentiel formant la zone de filtrage du pixel considérée.

En raison du défaut de planéité du substrat de support, la surface réfléchissante, formée à l'interface entre la couche de colle et le substrat de support, présente une topologie non plane, avec des creux et/ou des bosses. La cavité optique présente donc une épaisseur variable, qui dépend de l'emplacement considéré dans un plan parallèle au plan de la matrice de photodiodes (l'épaisseur de la cavité optique étant définie quant à elle selon un axe orthogonal au plan de la matrice de zones de filtrage). En outre, en utilisation, le dispositif de photo-détection est porté à très basses températures, ce qui exacerbe les variations d'épaisseur de la cavité optiques, en raison de la différence de coefficient de dilatation thermique entre le matériau de la couche active et le ou les matériau(x) de la matrice de zones de filtrage.

Or, plus la couche de colle est fine, plus cette cavité est sensible à des variations de son épaisseur. Cette plus forte sensibilité de la cavité optique à l'égard de variations de son épaisseur, se traduit par de plus fortes disparités d'un taux de lumière atteignant les photodiodes, d'un pixel à l'autre, et donc par une plus forte disparité d'un coefficient d'efficacité quantique, d'un pixel à l'autre. En outre, la variation d'épaisseur de la cavité affecte différemment les coefficients d'efficacité quantique, selon que le pixel considéré comporte une zone de filtrage du premier type ou une zone de filtrage du deuxième type (notamment parce qu'un coefficient de dilatation thermique de la zone de filtrage dépend du type de ladite zone de filtrage).

Afin de garantir une bonne reconstruction des couleurs, l'homme du métier cherche à réaliser un dispositif qui présente à la fois une faible diaphonie (entre les pixels comportant une zone de filtrage du premier type et les pixels comportant une zone de filtrage du deuxième type), et une grande homogénéité d'un coefficient d'efficacité quantique (sur tous les pixels dudit dispositif). Ces deux exigences semblent à première vue contradictoires, puisqu'une faible diaphonie est apportée par une couche de colle la plus fine possible, et une grande homogénéité du coefficient d'efficacité quantique est apportée par une couche de colle épaisse (pour limiter la sensibilité de la cavité optique à l'égard de variations de son épaisseur). Une fois ce problème posé, la solution évidente aurait consisté à rechercher un compromis sur l'épaisseur moyenne de la couche de colle.

Ici, les inventeurs ont eu l'idée de trouver une solution à ce problème à l'aide d'un revêtement antireflet, entre la couche de colle et le substrat de support, configuré pour limiter des réflexions parasites dans l'infrarouge qui seraient formées sinon à l'interface entre la couche de colle et le substrat de support. On peut ainsi obtenir un dispositif de photo-détection qui présente à la fois une faible diaphonie (entre les pixels comportant une zone de filtrage du premier type et les pixels comportant une zone de filtrage du deuxième type, notamment), grâce à une épaisseur réduite de la couche de colle, et une efficacité quantique sensiblement homogène d'un pixel à l'autre. On améliore ainsi une reconstruction de couleurs, en comparaison avec l'art antérieur.

Le revêtement antireflet, disposé entre le substrat de support et la couche de colle, en contact physique direct avec la couche de colle, présente dans cette configuration un taux de réflexion qui est de préférence strictement inférieur à 1%, et même strictement inférieur à 0,5% voire même inférieur à 0,1%, aux longueurs d'onde détectées par les photodiodes de la matrice de longueurs d'onde et transmises par l'une au moins des zones de filtrage. Les caractéristiques du revêtement antireflet sont adaptées pour obtenir un tel taux de réflexion, compte tenu de l'indice de réfraction de la couche de colle aux longueurs d'onde considérées (par exemple entre 1,5 et 1,6 aux longueurs d'onde considérées). On obtient un tel taux de réflexion, par exemple en optimisant une épaisseur du revêtement antireflet. Par exemple, le revêtement antireflet est constitué d'une couche de ZnS, d'épaisseur adaptée pour avoir un tel taux de réflexion lorsqu'elle est recouverte par la couche de colle.

Le dispositif selon l'invention combine les avantages ci-dessous :

- robustesse et compacité, grâce à des éléments constitutifs qui sont maintenus solidaires les uns des autres ;
- un étage de filtrage sans défaut de planéité, malgré l'hybridation d'un circuit de lecture sous la couche active ; et
- faible diaphonie et une grande homogénéité de l'efficacité quantique.

De préférence, une topologie de surface du substrat de support présente une amplitude pic-vallée supérieure ou égale à 3 $\mu$m à 300 K, du côté de la couche de colle, et une topologie de surface de l'étage de filtrage présente une topologie de surface avec une amplitude pic-vallée inférieure ou égale à 300 nm à 300 K, du côté de la couche de colle, une différence entre ces deux topologies de surface étant compensée par des variations d'épaisseur de la couche de colle.

Le dispositif selon l'invention peut comporter en outre une matrice de microlentilles, qui s'étend entre la couche de colle et l'étage de filtrage.

Dans au moins une direction de l'espace, un pas de répartition des microlentilles de la matrice de microlentilles peut être un multiple d'un pas de répartition des photodiodes de la matrice de photodiodes.

De préférence, le dispositif selon l'invention comporte en outre des murs métalliques, qui s'étendent dans la couche de filtrage, entre des zones de filtrage voisines.

Les murs métalliques peuvent s'étendre ensemble selon une grille, avec dans chaque ouverture de la grille au moins une zone de filtrage de la matrice de zones de filtrage.

Chaque ouverture de la grille comporte avantageusement une et unique zone de filtrage de la matrice de zones de filtrage.

De préférence, une partie au moins de l'un au moins des murs métalliques, est encadrée par deux cloisons intermédiaires en matériau diélectrique.

Une épaisseur des cloisons intermédiaires, définie dans un plan orthogonal à l'axe optique, est comprise avantageusement entre 500 nm et 50 nm.

De préférence, chaque zone de filtrage du premier type est constituée par un empilement de couches chacune en matériau diélectrique.

Chaque zone de filtrage du deuxième type peut être apte à transmettre les longueurs d'onde de la deuxième bande spectrale et les longueurs d'onde de la première bande spectrale, et constituée d'un matériau diélectrique nommé matériau de remplissage.

En variante, chaque zone de filtrage du deuxième type peut être apte à transmettre les longueurs d'onde de la deuxième bande spectrale et à bloquer les longueurs d'onde de la deuxième bande spectrale, et constituée par un filtre interférentiel respectif.

La couche active peut être en alliage de cadmium, mercure et tellure.

L'invention concerne également un système comportant un dispositif selon l'invention, et un refroidisseur cryogénique couplé thermiquement au dispositif selon l'invention, et apte à refroidir ledit dispositif jusqu'à des températures inférieures ou égales à 200 K.

**BRÈVE DESCRIPTION DES DESSINS**

La présente invention sera mieux comprise à la lecture de la description d'exemples de réalisation donnés à titre purement indicatif et nullement limitatif, en faisant référence aux dessins annexés sur lesquels :

[Fig. 1] illustre, selon une vue en coupe dans un plan vertical, un dispositif de photo-détection selon un premier mode de réalisation de l'invention ;
[Fig. 2] illustre, selon une vue en coupe dans un plan vertical, un dispositif de photo-détection selon un deuxième mode de réalisation de l'invention ;
[Fig. 3A] et
[Fig. 3B] illustrent un dispositif de photo-détection selon un troisième mode de réalisation de l'invention, respectivement selon une vue en coupe dans un plan vertical et selon une vue en coupe dans un plan horizontal ;
[Fig. 4A] et
[Fig. 4B] illustrent un dispositif de photo-détection selon un quatrième mode de réalisation de l'invention, respectivement selon une vue en coupe dans un plan vertical et selon une vue en coupe dans un plan horizontal ;

[Fig. 5] illustre, selon une vue en coupe dans un plan vertical, un dispositif de photo-détection selon un cinquième mode de réalisation de l'invention ; et

[Fig. 6] illustre, selon une vue en coupe dans un plan horizontal, un dispositif de photo-détection selon un sixième mode de réalisation de l'invention.

## EXPOSÉ DÉTAILLÉ DE MODES DE RÉALISATION PARTICULIERS

Pour faciliter la lecture, on a représenté sur les figures les axes d'un repère orthonormé (Oxyz). L'axe (Oz) définit un axe vertical, tandis que le plan (Oxy) définit un plan horizontal.

Dans tout le texte, le terme « infrarouge » se rapporte à une partie du spectre lumineux appartenant à une bande spectrale allant de 0,78 $\mu$m à 50 $\mu$m, plus préférentiellement de 3 $\mu$m à 8 $\mu$m (moyen infrarouge, ou LWIR) et/ou de 8 $\mu$m à 15 $\mu$m (infrarouge lointain, ou LWIR).

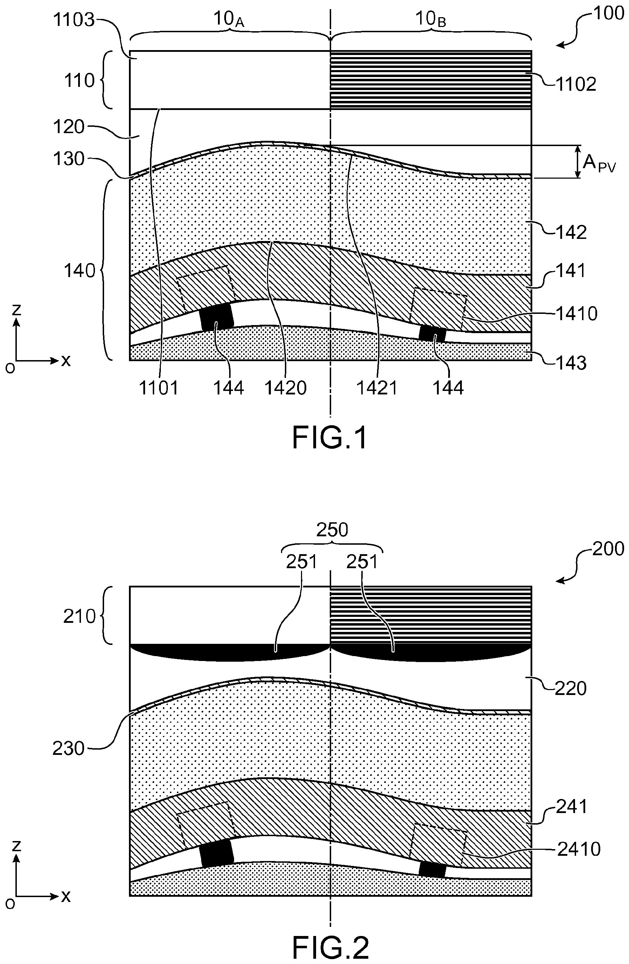

La figure 1 illustre de manière schématique, selon une vue en coupe dans un plan vertical (Oxz), un dispositif de photo-détection 100 selon un premier mode de réalisation de l'invention.

En utilisation, le dispositif photo-détection 100 est couplé à un refroidisseur de type refroidisseur cryogénique, pour abaisser sa température à des températures ultra-basses, dites cryogéniques, notamment des températures inférieures ou égales à 200 K, et même inférieures ou égales à 150 K, voire inférieures ou égales à 120 K.

Le dispositif de photo-détection 100 comporte, superposés dans cet ordre de long de l'axe (Oz) : un étage de filtrage 110, une couche de colle 120, un revêtement antireflet 130, et un étage de photo-détection 140.

L'étage de photo-détection 140 comporte un substrat semi-conducteur 141, nommé couche active, un substrat de support 142, et un circuit de lecture 143, superposés ensemble le long de l'axe optique (Oz) avec la couche active 141 entre le substrat de support 142 et le circuit de lecture 143.

Une matrice de photodiodes est intégrée dans la couche active 141. Les photodiodes 1401 de ladite matrice sont représentées de manière schématique par des pointillés. Les photodiodes 1410 sont réparties dans l'espace selon un agencement matriciel, par exemple selon des lignes et des colonnes. Chaque photodiode 1410 définit ici un pixel respectif de la matrice de photodiodes, ainsi qu'un pixel respectif 10$_A$ ou 10$_B$ du dispositif de photo-détection 100. En particulier, chaque pixel du dispositif de photo-détection 100 est délimité par des surfaces verticales s'étendant sur toute la hauteur du dispositif 100, et incorpore une et unique photodiode 1410. Sur la figure 1, on a identifié par un trait mixte la frontière entre les pixels 10$_A$ et 10$_B$.

La couche active 141 est constituée ici d'un alliage de cadmium, mercure et tellure (HgCdTe). L'invention n'est pas limitée à ce matériau, la couche active 141 pouvant également être constituée d'un alliage semi-conducteur en matériau III-V tel que l'arséniure de gallium, l'arséniure d'indium, le nitrure de gallium, l'antimoniure de gallium, ou un alliage ternaire tel que InxGa1-xAs, etc. Un matériau III-V désigne un matériau composé d'un ou plusieurs éléments de la colonne III du tableau périodique de Mendeleïev (par exemple le bore, le gallium, l'aluminium, l'indium, etc) et de la colonne V du même tableau (par exemple l'arsenic, l'antimoine, le phosphore, etc.).

Le substrat de support 142 peut correspondre à la partie résiduelle d'un substrat de croissance de la couche active 141, après amincissement de ce dernier. Le substrat de support 142 permet d'apporter une rigidité mécanique suffisante au dispositif 100, notamment en utilisation à basse température. L'épaisseur du substrat de support 142, mesurée selon l'axe (Oz), est de préférence supérieure ou égale à 10 $\mu$m, comprise par exemple entre 10 $\mu$m et 20 $\mu$m. Avec une couche active 141 en HgCdTe, le substrat de support 142 est avantageusement en alliage de zinc, mercure et tellure (HgZnTe).

Le circuit de lecture 143 est configuré pour recevoir des photo-courants générés au niveau des photodiodes 142, et les convertir en grandeurs physiques de type courant électrique, tension électrique, ou charge électrique, compatible avec des chaînes de traitement de signal. Le circuit de lecture 143 est connecté électriquement aux photodiodes 1410, ici par une série de billes d'indium 144 qui s'étendent chacune entre l'une photodiode 1410 de la couche active 141 et le circuit de lecture 143.

L'étage de photo-détection 140 forme ainsi un composant dit « hybridé », incorporant à la fois un circuit de détection (la couche active 141 comportant les photodiodes) et un circuit de lecture des photodiodes (le circuit de lecture 143).

La couche active 141 présente en pratique un certain défaut de planéité. Les plus grandes faces de la couche active 141, au lieu de s'étendre dans des plans parallèles au plan (Oxy), présentent en effet une forme non plane avec au moins un creux et/ou au moins une bosse. En utilisation, le dispositif de photo-détection 100 est porté à très basse température, ce qui exacerbe le défaut de planéité, du fait de la différence de coefficient de dilatation thermique entre le matériau du circuit de lecture 143 et le matériau de la couche active 141.

A la fabrication, la couche active 141 est formée sur un substrat de croissance, puis hybridée avec le substrat de lecture, puis le substrat de croissance est aminci afin d'obtenir le substrat de support 142. Le substrat de support 142 s'étend adjacent à la couche active 141, et présente une épaisseur sensiblement constante. L'amincissement réalise une certaine planarisation du dispositif de photo-détection 100. Cette planarisation n'est cependant que partielle, de sorte que le défaut de planéité de la couche active 141 se retrouve au moins en partie au niveau du substrat de support 142. En particulier, la face supérieure 1421 du substrat de support 142, située du côté opposé à la couche active 141, présente une topologie de surface avec au moins un creux et/ou au moins une bosse. Une topologie de surface de la face supérieure 1421 du substrat de support 142 présente par exemple une amplitude pic-vallée $A_{PV}$ supérieure ou égale à 3 $\mu$m à 300 K, comprise par exemple entre 4 $\mu$m et 5 $\mu$m à 300 K. Cette amplitude pic-vallée $A_{PV}$ est atteinte généralement sur une distance d'au moins vingt pixels du dispositif 100. Cette amplitude est augmentée lorsque le dispositif 100 est porté à des températures cryogéniques, en utilisation.

La couche de colle 120 s'étend au-dessus de la face supérieure 1421 du substrat de support 142. La couche de colle 120 permet de solidariser l'étage de filtrage 110 sur l'étage de photo-détection 140, et s'étend plus particulièrement entre l'étage de filtrage 110 et le substrat de support 142. Elle est constituée de préférence par une colle polymère.

Du côté du substrat de support 142, la couche de colle 120 épouse la forme de la face supérieure 1421 du substrat de support 142, laquelle présente une grande amplitude pic-vallée. Du côté de l'étage de filtrage 110, la couche de colle 120 épouse la forme d'une face inférieure 1101 de l'étage de filtrage 110, laquelle présente au contraire une topologie sensiblement planaire, proche d'un plan parallèle au plan (Oxy). Une topologie de surface de la face inférieure 1101 de l'étage de filtrage 110 présente par exemple une amplitude pic-vallée inférieure ou égale à 300 nm à 300 K, et même inférieure ou égale à 100 nm voire même inférieure ou égale à 50 nm à 300 K. Le défaut de planéité apporté par l'hybridation, et exacerbé par la mise à froid, est donc compensé par des variations d'épaisseur de la couche de colle 120. La couche de colle 120 permet donc que l'étage de filtrage 110 présente une topologie sensiblement planaire, malgré le défaut de planéité de l'étage de photo-détection 140 situé en-dessous. L'épaisseur moyenne de la couche de colle est avantageusement la plus petite épaisseur de colle permettant une compensation d'au moins 90% du défaut de planéité, en valeur d'amplitude pic-vallée. Cela permet de rapprocher le plus possible l'étage de filtrage 110 et la matrice de photodiodes 1410, et ainsi de limiter la diaphonie dans le dispositif 100. La diaphonie, ou en anglais le « crosstalk », désigne la détection d'un signal, par une photodiode d'un pixel, généré par de la lumière incidente sur un pixel voisin. Une autre façon de rapprocher l'étage de filtrage 110 et la matrice de photodiodes 1410 peut consister à réduire l'épaisseur du substrat de support 142. Cette solution est cependant limitée par le fait que la stabilité mécanique du dispositif 100, notamment lors de cycles thermiques de mise à froid et de retour à température ambiante, est apportée par le substrat de support 142. Ce dernier doit donc présenter une épaisseur assez importante.

L'étage de filtrage 110 est constitué ici d'une matrice de zones de filtrage. La matrice de zones de filtrage comporte au moins deux types distincts de zones de filtrage, qui diffèrent en particulier par leur bande spectrale de transmission respectives. Ici, la matrice de zones de filtrage comporte un premier type de zone de filtrage 1102, et un deuxième type de zone de filtrage 1103. Ici, les zones de filtrage voisines sont agencées directement adjacentes deux à deux, en contact physique selon toute la surface de leurs faces respectives situées au regard l'une de l'autre. Chaque pixel du dispositif 100 comporte ici une et unique zone de filtrage de l'étage de filtrage 110. Chaque zone de filtrage surmonte donc une et unique photodiode 1410.

Chaque zone de filtrage 1102 du premier type est formée par un filtre interférentiel respectif, apte à transmettre les longueurs d'onde d'une première bande spectrale dans l'infrarouge et à bloquer les longueurs d'onde d'une deuxième bande spectrale dans l'infrarouge. Par transmettre, on comprend laisser passer avec un coefficient de transmission supérieur ou égal à 80%, voire supérieur ou égal à 90% et même supérieur ou égal à 98%. Par bloquer, on entend empêcher le passage avec un coefficient de transmission inférieur ou égal à 5%, voire inférieur ou égal à 1% et même strictement inférieur à 0,1%. Chacune parmi la première bande spectrale et la deuxième bande spectrale recouvre une partie d'une bande de sensibilité spectrale de la matrice de photodiodes intégrée dans la couche active 141. Avantageusement, la première bande spectrale et la deuxième bande spectrale recouvrent ensemble l'intégralité de ladite bande de sensibilité spectrale. Chaque zone de filtrage 1102 du premier type est par exemple un filtre passe bande, ou passe-haut, ou passe-bas. Ici, chaque zone de filtrage 1102 du premier type est par exemple un filtre passe-bande, apte à transmettre uniquement les longueurs d'onde de la première bande spectrale dans l'infrarouge. La largeur de la première bande spectrale est comprise par exemple entre 300 nm et 800 nm. La première bande spectrale s'étend par exemple de 3,40 $\mu$m à 3,95 $\mu$m, ou de 4,60 $\mu$m à 5,05 $\mu$m. Chaque zone de filtrage du premier type est constituée ici d'un empilement de couches en matériau diélectrique, par exemple de couches Si et $SiO_2$ ou des couches Si et SiN.

Chaque zone de filtrage 1103 du deuxième type est apte à transmettre une partie au moins des longueurs d'onde bloquées par une zone de filtrage du deuxième type. Ici, chaque zone de filtrage 1103 du deuxième type est constituée par un simple matériau de remplissage, diélectrique, qui transmet à la fois les longueurs d'onde de la première bande spectrale et les longueurs d'onde de la deuxième bande spectrale. De préférence, chaque zone de filtrage 1103 du deuxième type forme ainsi une zone transparente, qui transmet toutes les longueurs d'onde de la bande de sensibilité spectrale de la matrice de photodiodes intégrée dans la couche active. Chaque zone de filtrage 1103 du deuxième type, constituée par un simple matériau de remplissage, présente ainsi une composition chimique homogène sur tout son volume. Le matériau de remplissage présente un indice de réfraction de préférence inférieur à 2,5. Il s'agit par exemple de nitrure de silicium. La hauteur d'une zone de filtrage 1103, selon l'axe (Oz), est égale à la hauteur d'une zone de filtrage 1102, selon le même axe.

Les photodiodes 1410 sont sensibles aux longueurs d'onde d'une partie au moins de chacune des première et deuxième bandes spectrales. Le dispositif 100 forme ainsi un dispositif pour la mise en oeuvre d'une détection de photons, dans l'infrarouge. Il est apte à discriminer les photons d'au moins deux bandes spectrales distinctes (détection multispectrale, ici bispectrale).

Dans l'étage de filtrage 110, chaque zone de filtrage est avantageusement entourée, sur ses quatre côtés (sauf cas particulier d'une zone de filtrage située en bordure de matrice), par des zones de filtrage d'un type différent du sien. On s'assure ainsi d'un maillage optimal des différentes bandes spectrales détectées, sur la surface de détection du dispositif 100.

Dans le dispositif 100, le pas de répartition des pixels $10_A$, $10_B$ est de préférence strictement supérieur à une valeur maximale de longueurs d'onde transmise par l'une ou l'autre des zones de filtrage et détectée par les photodiodes. Ici, ce pas de répartition est par exemple compris entre 8 $\mu$m et 15 $\mu$m.

Selon l'invention, un revêtement antireflet 130 s'étend entre la face supérieure 1421 du substrat de support 142 et la face inférieure de la couche de colle 120, en contact physique direct avec ces dernières sur toute leurs étendues respectives. Le revêtement antireflet 130 présente une épaisseur réduite, constante selon l'axe (Oz). Ainsi, la topologie de surface de la face supérieure 1421 du substrat de support 142 est identique à la topologie de surface de la face inférieure de la couche de colle 120. Le revêtement antireflet 130 est configuré pour limiter des réflexions internes dans le dispositif 100, qui existeraient sinon à l'interface entre la couche de colle 120 et le substrat de support 142. Il présente un caractère antireflet sur une large bande spectrale, qui inclut l'ensemble des longueurs d'onde aptes à être transmises par l'étage de filtrage et détectées par l'étage de photo-détection. Son caractère antireflet est défini par un taux de réflexion très faible sur ladite bande spectrale. Ce taux de transmission est défini en association avec l'agencement du revêtement antireflet 130 sous la couche de colle 120, en contact physique direct avec cette dernière. Ici, le revêtement antireflet 130 présente un coefficient de réflexion strictement inférieur à 1% aux longueurs d'onde aptes à être transmises par l'étage de filtrage et détectées par l'étage de photo-détection, lorsqu'il est recouvert par la couche de colle 120 et en contact physique direct avec cette dernière. Le revêtement antireflet peut-être monocouche, ou bicouche, ou même multicouche avec au moins trois couches. Il est constitué d'un ou plusieurs matériaux d'indice de réfraction intermédiaire entre celui de la couche de colle 120 et celui du substrat de support 141. Il comprend de préférence une couche en ZnS ou en ZnSe. Ici, le revêtement antireflet est constitué d'une couche unique en ZnS ou en ZnSe. Son épaisseur est optimisée, via une optimisation logicielle, et compte tenu de l'indice de réfraction de la couche de colle 120, éventuellement de l'indice de réfraction du substrat de support 142, et de la longueur d'onde centrale d'une plage spectrale utile (incluant l'ensemble des longueurs d'onde aptes à être transmises par l'étage de filtrage et détectées par l'étage de photo-détection). Ici, la longueur d'onde centrale vaut environ 4 $\mu$m.

En utilisation, la lumière infrarouge arrive sur le dispositif de photo-détection 100 au niveau de l'étage de filtrage 110, du côté opposé à l'étage de photo-détection 140, et orientée selon un faisceau sensiblement parallèle à l'axe (Oz). Un axe optique du dispositif 100 s'étend parallèle à l'axe (Oz), et orthogonal au plan (Oxy) de l'étage de filtrage. Dans chaque pixel du dispositif 100, de la lumière infrarouge traverse une zone de filtrage de l'étage de filtrage, puis traverse le substrat de support 142, puis parvient jusqu'à la couche active 141 où ladite lumière est détectée par la photodiode 1410 dudit pixel. La présence du revêtement antireflet 130 permet de limiter l'apparition de réflexions internes dans le dispositif 100, notamment des réflexions générées sinon à l'interface entre la couche de colle 120 et le substrat de support 142.

En l'absence du revêtement antireflet 130, il se forme en effet des réflexions parasites, à l'interface entre la couche de colle 120 et le substrat de support 142. Ces réflexions parasites se trouvent confinées, dans une cavité optique délimitée notamment par l'interface entre la couche de colle 120 et le substrat de support 142. En raison du défaut de planéité du substrat de support 142, cette cavité optique présente une épaisseur variable, fonction de l'emplacement considéré dans un plan (Oxy). Un taux de lumière infrarouge, provenant d'une scène extérieure à imager et parvenant jusque dans l'étage de photo-détection 140 pour y être détectée par les photodiodes, est fonction de l'épaisseur locale de la cavité optique, à l'emplacement considéré dans un plan (Oxy). Ce taux de lumière infrarouge est donc variable, et dépend de l'emplacement considéré dans un plan (Oxy). Lorsque l'épaisseur de la couche de colle 120 tend vers la longueur de cohérence de la lumière infrarouge provenant de la scène extérieure à imager et parvenant jusque dans l'étage de photo-détection 140, ce taux de lumière infrarouge varie peu. Cette longueur de cohérence est typiquement de l'ordre de 30 à 40 $\mu$m. Cependant, ici, l'épaisseur moyenne de la couche de colle 120 est très inférieure à ces valeurs, afin de réduire la diaphonie. Par conséquent, ce taux de lumière infrarouge varie fortement, en l'absence du revêtement antireflet 130. Cela se traduit par de fortes variations d'efficacité quantique, d'un pixel à l'autre du dispositif 100.

En outre, lorsque le dispositif 100 est porté à des températures cryogéniques, les variations d'épaisseur de la cavité optique mentionnée ci-dessus sont exacerbées par la différence de coefficient de dilatation thermique entre le matériau de la couche active 141 et l'étage de filtrage 110. En outre, l'épaisseur de la cavité optique peut être impactée de manière différente, selon qu'elle s'étend au niveau d'une zone de filtrage du premier type ou du second type (une zone de filtrage du premier type et une zone de filtrage du second type pouvant présenter chacune des coefficients de dilatation thermique distincts). Cela se traduit par une augmentation des variations d'efficacité quantique, d'un pixel à l'autre du dispositif 100.

Grâce au revêtement antireflet 130, on limite ces variations d'efficacité quantique, tout en garantissant une diaphonie réduite grâce à la proximité entre l'étage de filtrage 110 et la matrice de photodiodes. Cela permet *in fine* une meilleure reconstruction des couleurs sur une image formée à l'aide du dispositif 100.

La figure 2 illustre de manière schématique, selon une vue en coupe dans un plan vertical (Oxz), un dispositif de photo-détection 200 selon un deuxième mode de réalisation de l'invention. Ce deuxième mode de réalisation ne diffère du mode de réalisation de la figure 1 qu'en ce qu'il comporte en outre une matrice 250 de microlentilles 251, qui s'étend entre l'étage de filtrage 210 et la couche de colle 220. Ici, les microlentilles 251 s'étendent chacune en contact physique direct avec l'étage de filtrage 210 et avec la couche de colle 220. Les microlentilles 251 sont délimitées ici par une face plane, adjacente à l'étage de filtrage 210, et une face bombée convexe, adjacente à la couche de colle 220. La face supérieure de la couche de colle 220, du côté opposé au substrat de support, suit ici la topologie de la matrice 250 de microlentilles.

Ici, chaque pixel du dispositif 200 comporte une et unique photodiode 2410 et une et unique microlentille 251. Les microlentilles 251 sont configurées chacune pour focaliser la lumière incidente dans la couche active 241, dans une région d'absorption de la photodiode 2410 associée au même pixel. La lumière est focalisée dans une zone centrale de ladite zone d'absorption, pour limiter une diaphonie liée à la diffusion de porteurs dans la couche active.

La solution évidente pour positionner les microlentilles consiste à placer ces dernières au-dessus de l'étage de filtrage, du côté opposé à la couche de colle. Les inventeurs ont eu l'idée de les placer plutôt entre l'étage de filtrage 210 et la couche de colle 220. L'agencement des microlentilles sous l'étage de filtrage 210, entre l'étage de filtrage 210 et la couche de colle 220, permet que la longueur focale des microlentilles soit réduite, et n'augmente pas avec l'épaisseur de l'étage de filtrage 210.

Cette particularité est particulièrement utile ici, puisque l'étage de filtrage doit présenter une forte épaisseur afin de pouvoir filtrer de la lumière dans l'infrarouge. Un agencement des microlentilles au-dessus de l'étage de filtrage se traduirait donc par une très grande longueur focale de ces dernières. Or, une grande longueur focale des microlentilles se traduit par un grand diamètre de la tâche d'Airy, ce qui peut générer des défauts de diaphonie, voire même rendre les microlentilles inutiles, par exemple si le diamètre de la tâche d'Airy dépasse le pas de répartition des photodiodes 2410. Cette problématique de diaphonie est liée au contexte infrarouge, dans lequel les diamètres de tâche d'Airy sont bien plus grands que dans le visible. La réduction de diaphonie est une problématique encore plus importante lorsque la couche active est en alliage de cadmium, mercure et tellure, ce type d'alliage pouvant être plus sujet à de la diaphonie électronique.

Ici, l'agencement original des microlentilles permet donc d'améliorer encore un rendu des couleurs, en évitant de générer de la diaphonie via une augmentation du diamètre de la tâche d'Airy. Cet agencement original des microlentilles permet en outre d'augmenter librement une épaisseur de l'étage de filtrage, par exemple pour améliorer la qualité d'un filtrage spectral mis en oeuvre par ce dernier, sans conséquences négatives sur la diaphonie.

Le matériau des microlentilles 251 présente un indice de réfraction élevé. Par conséquent, leur positionnement entre l'étage de filtrage 210 et la couche de colle 220 exacerbe des modulations de signal optique liées aux variations d'épaisseur de la cavité optique décrite en référence à la figure 1. Le revêtement antireflet 230 décrit en référence à la figure 1 trouve donc ici un intérêt supplémentaire.

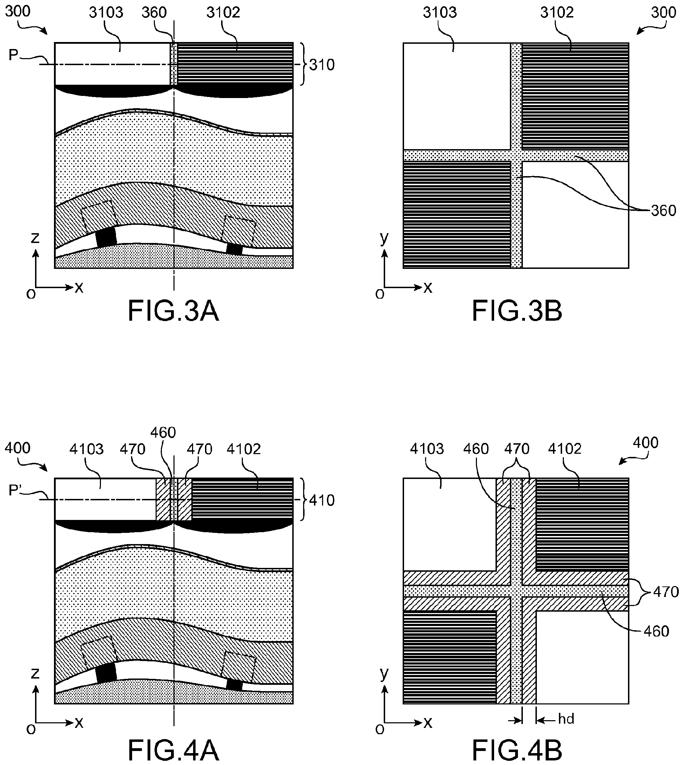

Les figures 3A et 3B illustrent un dispositif 300 selon un troisième mode de réalisation, qui ne sera décrit que pour ses différences relativement au mode de réalisation de la figure 2. La figure 3A est une vue en coupe dans un plan vertical (Oxz). La figure 3B est une vue en coupe dans un plan horizontal P, parallèle au plan (Oxy) et passant par l'étage de filtrage 310.

Dans le dispositif 300, des murs métalliques 360 s'étendent entre des zones de filtrage voisines de l'étage de filtrage 310, pour séparer des zones de filtrage associées à des bandes spectrales transmises distinctes. Ici, les murs métalliques 360 s'étendent entre des couples de deux zones de filtrage, comportant chacun une zone de filtrage 3102 du premier type et une zone de filtrage 3103 du deuxième type.

Les murs métalliques 360 sont constitués d'au moins un métal, et formés de préférence en cuivre. Ils forment des structures verticales, délimitées par des parois sensiblement orthogonales au plan (Oxy). Ces parois sont inclinées de préférence de moins de 10°, relativement à la normale au plan (Oxy).

Les murs métalliques 360 s'étendent de préférence selon toute la hauteur, selon (Oz), de l'étage de filtrage 310. Ils s'étendent le long de lignes définies dans des plans parallèles au plan (Oxy), ici des lignes droites. Leur épaisseur est sensiblement constante le long de ces lignes. Ici, les murs métalliques 360 sont en contact physique direct avec chacune des zones de filtrage voisines.

Les murs métalliques 360 s'étendent ici selon une série de lignes droites qui s'étendent chacune d'un bord à l'autre de la matrice de zones de filtrage. Ils forment ensemble une grille. Ici, il y a une et unique zone de filtrage 3102, 3103 dans chaque trou de la grille. Dans des variantes non représentées, on peut avoir plusieurs zones de filtrage voisines dans chaque trou de la grille.

Ici, les murs métalliques 360 ne s'étendent pas le long des bords extérieurs de la matrice de zones de filtrage, de sorte que les zones de filtrage situées en bordure de matrice ne sont entourées par des murs métalliques que sur leurs bords situés à l'intérieur de la matrice. Selon une variante avantageuse, non représentée, l'étage de filtrage peut s'étendre selon une surface un peu plus étendue que la matrice de photodiodes dans la couche active. Ainsi les zones de filtrage situées en bordure de matrice, et qui ne sont pas entièrement entourées par des murs métalliques, ne s'étendent pas au-dessus d'une photodiode. Il y a ainsi des pixels « aveugles » en bordure de matrice, mais qui ne représente qu'une faible proportion du nombre total de pixels dans le dispositif.

Dans une variante non représentée, les murs s'étendent également le long des bords extérieurs de la matrice de zones de filtrage.

En utilisation, une onde incidente se couple avec des guides d'onde planaires formés par l'alternance de couches haut indice et bas indice dans une zone de filtrage 3102. Ces modes guidés, se propageant dans les couches haut indice d'une zone de filtrage sont généralement absents des filtres planaires. Ils existent ici du fait de la présence de structures diffractant la lumière, comme par exemple les coins des zones de filtrage, entre des pixels voisins. En l'absence des murs métalliques 360, de la lumière se propageant dans ces guides d'onde planaire peut être captée par un pixel voisin. Les murs métalliques 360 permettent de bloquer la propagation de ces modes guidés. Les murs métalliques 360 permettent ainsi de réduire une diaphonie, liée à la propagation de modes d'une zone de filtrage à l'autre de l'étage de filtrage. En pratique, les murs métalliques 360 permettent, dans chaque pixel du dispositif 200, de réduire une efficacité spectrale à des longueurs d'onde pourtant bloquées par la zone de filtrage associée audit pixel (quantité de lumière détectée par la photodiode, et provenant alors d'un pixel voisin dans lequel la zone de filtrage laisse passer ces longueurs d'onde).

Les modes TE et TM contribuent à cette diaphonie. Dans le cas où la zone de filtrage du deuxième type est constituée d'un matériau de remplissage de faible indice, ce sont les modes guidés TM qui contribuent le plus à la diaphonie.

Ici, les murs métalliques 360 sont encadrés par des couples de deux zones de filtrage, incluant une zone de filtrage constituée d'un empilement de couches en matériau diélectrique, et une zone de filtrage constituée d'un simple matériau de remplissage. Dans une variante de l'invention, les murs métalliques sont encadrés par des couples de deux zones de filtrage, incluant une zone de filtrage constituée d'un premier empilement de couches en matériau diélectrique, et une zone de filtrage constituée d'un deuxième empilement de couches en matériau diélectrique. Là encore, les murs métalliques permettent de réduire la diaphonie.

Dans d'autres variantes, les murs ne sont pas en métal, mais en matériau absorbant dans l'infrarouge (par exemple du silicium dopé)

Les figures 4A et 4B illustrent un dispositif 400 selon un quatrième mode de réalisation, qui ne sera décrit que pour ses différences relativement au mode de réalisation des figures 3A et 3B. La figure 4A est une vue en coupe dans un plan vertical (Oxz). La figure 4B est une vue en coupe dans un plan horizontal P', parallèle au plan (Oxy) et passant par l'étage de filtrage 410.

Dans ce mode de réalisation, le dispositif 400 comporte en outre des cloisons intermédiaires 470, en matériau diélectrique. Chaque cloison intermédiaire 470 forme une structure verticale, délimitée par des parois sensiblement orthogonales au plan (Oxy) de l'étage de filtrage 410. Les cloisons intermédiaires 470 s'étendent de préférence selon toute la hauteur, selon (Oz), de l'étage de filtrage 410. Elles s'étendent chacune selon une ligne située dans le plan (Oxy). Chaque cloison intermédiaire 470 présente de préférence une épaisseur constante le long de cette ligne.

Chaque cloison intermédiaire 470 s'étend ici en contact physique direct avec une portion respective d'un mur métallique, et avec un bord d'une zone de filtrage de la matrice de filtrage. On peut ainsi considérer qu'une cloison intermédiaire 470 recouvre une partie au moins d'un mur métallique.

Ici, les murs métalliques 460 définissent ensemble une grille, et des cloisons intermédiaires 470 recouvrent chacune des facettes verticales de la grille, entre une portion respective de mur métallique 460 et un bord respectif de zone de filtrage 4102, 4103. Chacune des zones de filtrage 4102, 4103 est donc entièrement entourée par des cloisons intermédiaires 470, exceptées ici les zones de filtrage situées en bordure de matrice qui ne sont entourées par des cloisons intermédiaires 470 que sur leurs bords situés à l'intérieur de la matrice. Sur la figure 4A, on a représenté une matrice de seulement quatre pixels, de sorte que toutes les zones de filtrage se trouvent en bordure de matrice, entourées sur seulement trois côtés.

Selon une variante avantageuse, non représentée, l'étage de filtrage peut s'étendre selon une surface un peu plus étendue que la matrice de photodiodes dans la couche active. Ainsi les zones de filtrage situées en bordure de matrice, et qui ne sont pas entièrement entourées par des murs métalliques et des cloisons intermédiaires, ne s'étendent pas au-dessus d'une photodiode. Il y a ainsi des pixels « aveugles » en bordure de matrice, mais qui ne représente qu'une faible proportion du nombre total de pixels dans le dispositif.

Dans une variante non représentée, les murs s'étendent également le long des bords extérieurs de la matrice de zones de filtrage. Dans ce cas, chacune des zones de filtrage 4102, 4103 est entièrement entourée par des cloisons intermédiaires 470.

Dans une autre variante, les murs métalliques définissent ensemble une grille, avec plusieurs zones de filtrage voisines dans chaque trou de la grille. Chaque cloison intermédiaire recouvre alors chacune des facettes verticales de la grille, le long de plusieurs zones de filtrage voisines.

En tout état de cause, chaque portion de mur métallique 460 située entre deux zones de filtrage voisines 4102, 4103, est ici encadrée par un couple respectif de deux cloisons intermédiaires 470. La structure formée par une portion de mur métallique 460 encadrée entre deux cloisons intermédiaires 470, est configurée pour modifier le champ électromagnétique à la sortie d'une zone de filtrage dite principale, de manière à diminuer la diffraction vers une zone de filtrage voisine. Les cloisons intermédiaires 470 servent en particulier à diminuer l'ouverture angulaire d'ondes lumineuses diffractées, émergeant d'une zone de filtrage 4103 du deuxième type et se propageant dans une zone de filtrage 4102 du premier type, où la zone de filtrage 4103 du deuxième type est constituée par un simple matériau de remplissage. Il s'agit de diminuer plus particulièrement la diffraction des modes TM, contribuant le plus à la diaphonie. Le rôle des cloisons intermédiaires 470 est d'éloigner le champ H des murs métalliques 460, ce qui résulte aussi entre autre en une moindre perte dissipative. On améliore ainsi la réduction d'une diaphonie. La modification de champ électrique est effective à une longueur d'onde de coupure, qui délimite la deuxième bande spectrale, transmise par une zone de filtrage 4103 du deuxième type, et la première bande spectrale, transmise par une zone de filtrage 41032 du premier type.

Il existe en outre un effet de synergie entre les cloisons intermédiaires 470 et les microlentilles situées sous l'étage de filtrage. En effet, le diamètre de la tâche d'Airy est diminué lorsque la lumière arrive sur les microlentilles sous la forme d'une onde sensiblement plane (l'onde étant planarisée par ladite diminution de la diffraction vers une zone de filtrage voisine).

On peut déterminer les conditions à vérifier pour obtenir cette modification de champ, à l'aide d'une étude paramétrique. Pour cela, on utilise l'équation paramétrique de l'indice effectif du mode fondamental TM dans une structure dite « MDD », pour Métal-Diélectrique-Diélectrique, constituée par un mur métallique entre deux cloisons intermédiaires, avec d'un côté une zone de filtrage du premier type et de l'autre côté une zone de filtrage du deuxième type constituée ici d'un simple matériau de remplissage. L'équation paramétrique peut dépendre de paramètres tels que la permittivité diélectrique moyenne dans la zone de filtrage du deuxième type, la permittivité diélectrique du mur métallique, la permittivité diélectrique des cloisons intermédiaires, et l'épaisseur hd des cloisons intermédiaires, (définie dans un plan (Oxy) parallèle au plan de la matrice de zones de filtrage). Ensuite, on recherche des valeurs des paramètres pour lesquels l'équation ne trouve pas de solution. Cela correspond à l'absence du mode fondamental TMO, et donc à l'absence des modes TM d'ordre supérieur. Les modes TE, bien sûr, subsistent. L'étude paramétrique est réalisée pour une longueur d'onde déterminée, égale ici à la longueur d'onde de coupure telle que mentionnée ci-dessus, délimitant la deuxième bande spectrale, transmise par une zone de filtrage 4103 du deuxième type, et la première bande spectrale, transmise par une zone de filtrage 41032 du premier type.

Les inventeurs ont montré que la modification de champ recherchée, est obtenue plus facilement lorsqu'un indice de réfraction des cloisons intermédiaires est strictement inférieur à un indice de réfraction moyen dans la zone de filtrage du deuxième type. On montre également que la modification de champ recherchée est obtenue pour une épaisseur hd non nulle, de préférence strictement inférieure à une valeur seuil déterminée. En outre, on montre que la permittivité diélectrique moyenne dans la zone de filtrage du deuxième type est avantageusement supérieure ou égale à 2, voire supérieure ou égale à 3.

On détaille ci-après une telle étude paramétrique, associée à une structure constituée d'un mur métallique encadré par deux cloisons intermédiaires, avec d'un côté une zone de filtrage 4102 constituée d'un empilement de couches diélectriques, et de l'autre côté une zone de filtrage 4103 constituée d'un simple matériau de remplissage. L'étude paramétrique permet de déterminer des paramètres permettant de modifier le champ électromagnétique à la sortie de la zone de filtrage 4103 (constituée d'un simple matériau de remplissage), de manière à diminuer la diffraction vers la zone de filtrage 4102, dans la gamme de longueurs d'onde bloquée par la zone de filtrage 4102 et transmise par le zone de filtrage 4103. L'étude paramétrique est basée sur une équation fonction de l'indice effectif du mode fondamental TM0, qui est alors le mode contribuant le plus à la diaphonie. L'étude paramétrique est réalisée pour une longueur d'onde de coupure égale à 4000 nm. L'indice effectif N vérifie l'équation ci-dessous :

$$k_d h_d = \arctan\left(\frac{\varepsilon_d k_a}{\varepsilon_0 k_d}\right) + \arctan\left(\frac{\varepsilon_d k_m}{\varepsilon_m k_d}\right) \qquad (1)$$

avec $k_m = k_0\sqrt{N^2 - \varepsilon_m}$ , $k_d = k_0\sqrt{\varepsilon_d - N^2}$ et $k_a = k_0\sqrt{N^2 - \varepsilon_0}$ et avec $\varepsilon_0$ la permittivité diélectrique du matériau de remplissage ; $\varepsilon_m$ la permittivité diélectrique des murs métalliques ; $\varepsilon_d$ la permittivité diélectrique des cloisons intermédiaires; et hd l'épaisseur des cloisons intermédiaires, considérée dans un plan (Oxy) parallèle au plan de la matrice de zones de filtrage.

L'étude paramétrique de l'équation (1) permet de déterminer des conditions dans lesquelles il n'existe pas de solution, c'est-à-dire des conditions pour lesquelles le mode fondamental TM0 n'existe pas dans ladite structure. On montre ainsi par exemple que, pour $\varepsilon 0=1$, un mode guidé TM0 existe pour toutes épaisseurs hd. En revanche, pour $\varepsilon 0=3$, il existe une valeur seuil de l'épaisseur hd, en-dessous de laquelle aucun mode guidé ne subsiste. Pour $\lambda=4000$ nm, on a en particulier

| hd ($\mu$m) | N |
|---|---|
| 1 | 1,79 |
| 0,95 | 1,79 |
| 0,8 | 1,79 |
| 0,7 | 1,8 |
| 0,6 | 0,18 |
| 0,5 | néant |

Enfin, pour hd=0, on retrouve à nouveau le mode TM0. Donc pour imposer un champ H qui soit nul à la surface du mur métallique, l'épaisseur des cloisons intermédiaires doit être ici inférieure à 500 nm et supérieure à 0 nm, par exemple comprise entre 500 nm et 50 nm. De manière avantageuse, cette épaisseur hd est comprise entre 80 nm et 150 nm, garantissant que le mode guidé TM0 ne subsiste que pour des longueurs d'onde très inférieures à 3000 nm. En outre, l'indice de réfraction nd dans les cloisons intermédiaires est avantageusement strictement inférieur à l'indice de réfraction n0 du matériau de remplissage à la longueur d'onde de coupure.

Une étude paramétrique similaire peut être mise en oeuvre, lorsque la structure comportant un mur métallique entre deux cloisons intermédiaire, s'étend entre une zone de filtrage constituée d'un premier empilement de couches en matériau diélectrique, et une zone de filtrage constituée d'un deuxième empilement de couches en matériau diélectrique.

Dans une variante de l'invention, les murs ne sont pas en métal, mais en matériau absorbant dans l'infrarouge (par exemple du silicium dopé).

A titre d'exemple, on décrit ci-après l'évolution de l'efficacité quantique QE d'un pixel, dans un dispositif selon l'invention. Les données chiffrées sont obtenues par simulation, et ne prennent en considération que la diaphonie optique. Le pixel considéré comporte une zone de filtrage apte à bloquer la lumière dans une bande spectrale B2, et à transmettre la lumière dans une bande spectrale B1. Dans un mode de réalisation tel qu'illustré en figure 1, le coefficient QE prend la valeur 69 sur la bande B1, et la valeur 15 sur la bande B2. Dans une variante qui ne diffère que par la présence supplémentaire de microlentilles, comme illustré à la figure 2, le coefficient QE prend la valeur 67 sur la bande B1, et la valeur 10 sur la bande B2. Dans une variante qui ne diffère que par la présence supplémentaire de murs métalliques, comme illustré aux figures 3A et 3B, le coefficient QE prend la valeur 70 sur la bande B1, et la valeur 8 sur la bande B2. Dans une variante qui ne diffère que par la présence supplémentaire de cloisons intermédiaires, comme illustré aux figures 4A et 4B, le coefficient QE prend la valeur 85 sur la bande B1, et la valeur 7 sur la bande B2. On confirme ainsi une diminution de plus en plus forte de la diaphonie, via l'ajout d'abord des microlentilles seulement, puis des murs métalliques, puis des cloisons intermédiaires. Au fur et à mesure de la diminution de la diaphonie, la quantité de lumière dans la bande spectrale B1, passant dans un pixel voisin, diminue. L'efficacité quantique QE dans la bande spectrale B1 augmente donc en conséquence. De même, au fur et à mesure de la diminution de la diaphonie, la quantité de lumière dans la bande spectrale B2, arrivant d'un pixel voisin dont le filtre transmet cette bande spectrale B2, diminue. L'efficacité quantique QE dans la bande spectrale B2 diminue donc en conséquence.

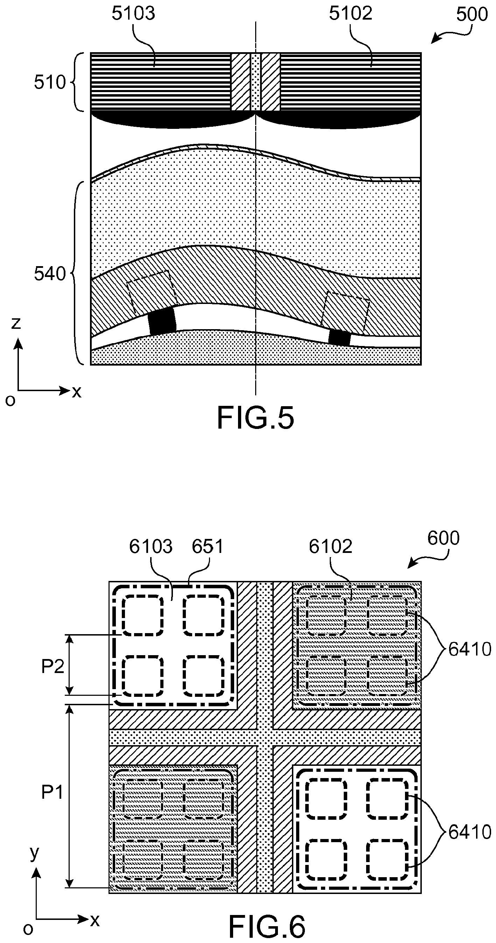

La figure 5 illustre de manière schématique, selon une vue en coupe dans un plan vertical (Oxz), un dispositif de photo-détection 500 selon un cinquième mode de réalisation de l'invention.

Ce mode de réalisation ne diffère de celui des figures 4A et 4B qu'en ce que, dans l'étage de filtrage 510, les zones de filtrage 5102 du premier type sont aptes à transmettre les longueurs d'onde d'une première bande spectrale et à bloquer les longueurs d'onde d'une deuxième bande spectrale, et les zones de filtrage 5103 du deuxième type sont aptes à transmettre les longueurs d'onde de la deuxième bande spectrale et à bloquer les longueurs de la première bande spectrale. Les photodiodes intégrées dans l'étage de photo-détection 540 sont sensible à la fois aux longueurs d'onde de la première bande spectrale et aux longueurs d'onde de la deuxième bande spectrale. Chacune des zones de filtrage du premier et du deuxième type est constituée alors par un filtre interférentiel respectif. Chacun desdits filtres interférentiels est constitué d'un empilement de couches en matériau diélectrique. De préférence, il n'existe pas de couche qui soit commune aux zones de filtrage du premier type et aux zones de filtrage du deuxième type.

On retrouve dans ce mode de réalisation des avantages similaires à ceux du mode de réalisation des figures 4A et 4B.

La figure 6 illustre de manière schématique, selon une vue en coupe dans un plan horizontal (Oxy), un dispositif de photo-détection 600 selon un sixième mode de réalisation de l'invention.

Sur la figure 6, on a représenté en transparence les photodiodes 6410 intégrées dans la couche active et les microlentilles 651 de la matrice de microlentilles. Le dispositif 600 ne diffère du dispositif des figures 4A et 4B, qu'en ce qu'un pas de répartition P1 des microlentilles 651 est un multiple d'un pas de répartition P2 des photodiodes 6410 (ici dans chacun des axes (Ox) et (Oy) desdites matrices).

Les zones de filtrage 6102, 6103 de la matrice de zones de filtrage sont réparties ici selon le même pas de répartition que les microlentilles, avec une et unique zone de filtrage au-dessus de chaque microlentille. Ici, des murs métalliques encadrés par des cloisons intermédiaires s'étendent, selon une grille, entre les zones de filtrage de la matrice de zones de filtrage.

On peut ainsi définir, dans le dispositif 600, des macro-pixels comportant chacun une et unique zone de filtrage, une et unique microlentille, et une pluralité de photodiodes agencées en sous-matrice. Les microlentilles 651 sont configurées chacune pour focaliser la lumière incidente, dans la couche active, dans une région centrale du macro-pixel associé.

Ce mode de réalisation permet ainsi de diminuer une diaphonie entre les macro-pixels. En effet, dans la couche active, les porteurs de charge peuvent présenter une grande durée de vie et une grande longueur de diffusion (c'est notamment le cas dans une couche active en alliage cadmium, mercure, tellure). En focalisant la lumière au centre du macro-pixel, on s'assure que les porteurs de charge soient collectés par une photodiode associée au même macro-pixel, surmontée une même zone de filtrage que celle au niveau de laquelle la lumière est arrivée sur le dispositif 600. Il s'agit en d'autres termes d'augmenter une taille de pixel, en considérant plutôt des macro-pixels, sans modifier l'étage de photo-détection. Ce mode de réalisation est particulièrement adapté lorsque la couche active est dopée N, avec des régions dopées P définissant chacune une photodiode. Ce mode de réalisation est adapté notamment lorsque la couche active est en alliage cadmium, mercure, tellure, dopée N, avec des régions dopées P définissant chacune une photodiode, ou dans toute autre configuration pour laquelle une longueur de diffusion des porteurs de charge dans la couche active est de l'ordre de 20 $\mu$m.

Ici, chaque macro-pixel comporte une sous-matrice composée de quatre photodiodes réparties en deux lignes et deux colonnes. En variante, chaque macro-pixel peut comporter une sous-matrice composée de neuf photodiodes réparties en trois lignes et trois colonnes.

De préférence, le dispositif de photo-détection selon l'invention est couplé à un refroidisseur cryogénique, pour abaisser la température du dispositif de photo-détection aux températures cryogéniques, et pour réduire ainsi le bruit induit thermiquement à un niveau inférieur à celui du signal émis par la scène.

De préférence, le dispositif selon l'invention est dépourvu de microlentilles situées au-dessus de l'étage de filtrage, du côté opposé à l'étage de photo-détection. Les seules microlentilles, lorsqu'elles existent, s'étendent alors uniquement entre l'étage de filtrage et l'étage de photo-détection.

L'invention n'est pas limitée aux exemples décrits ci-dessus, et inclut de nombreuses autres variantes, avec des matériaux différents et/ou des dimensions différentes et/ou des gammes de longueur d'onde différentes. En outre, les différents modes de réalisation décrits dans les figures ci-dessus peuvent être combinés. Par exemple, le mode de réalisation de la figure 6 peut être combiné à celui des figures 3A et 3B ou à celui de la figure 2 ou de la figure 1. Selon d'autres variantes, la couche antireflet est plane, et l'étage de photo-détection ne présente pas de défaut de planéité. Selon d'autres variantes, les murs métalliques peuvent s'étendre d'un bord à l'autre du dispositif, selon des lignes discontinues.

Selon d'autres variantes encore, la matrice de zones de filtrage peut comporter des zones de filtrage d'au moins trois types distincts, pour pouvoir discriminer les longueurs d'onde d'au moins trois bandes spectrales distinctes. Chaque type de zone de filtrage laisse passer les longueurs d'onde d'une bande spectrale transmise spécifique. Chacune des bandes spectrales transmises recouvre une partie d'une bande de sensibilité spectrale de la matrice de photodiodes intégrée dans la couche active. Avantageusement, les différentes bandes spectrales transmises recouvrent ensemble l'intégralité de ladite bande de sensibilité spectrale.

L'invention couvre également un système, non représenté, comprenant un dispositif de photo-détection selon l'invention, et un refroidisseur cryogénique couplé thermiquement à ce dernier. En utilisation, le refroidisseur cryogénique refroidit ledit dispositif jusqu'à des températures cryogéniques, inférieures ou égales à 200 K, et même inférieures ou égales à 150 K, voire inférieures ou égales à 120 K. Un refroidisseur cryogénique désigne un dispositif apte à refroidir un détecteur infrarouge pour l'amener à des températures cryogéniques, et basé en général sur l'utilisation d'un gaz frigorifique.

Un dispositif selon l'invention peut être réalisé, à l'aide des étapes suivantes :

1/ dépôt d'un premier empilement multicouche sur un substrat initial en silicium ;

2/ gravures locales du premier empilement multicouche, pour former une série de filtres du premier type ;

3/ dépôt d'un matériau de remplissage (ou d'un deuxième empilement multicouche), remplissant les ouvertures gravées à l'étape 2/, pour former une série de filtres du deuxième type ;

4/ le cas échéant, gravure de tranchées entre les filtres du premier type et les filtres du deuxième type, au travers d'un masque de gravure, et à l'aide d'une gravure sèche standard non sélective allant jusqu'au substrat en silicium ;

5/ dépôt conforme de matériau diélectrique sur les tranches de gravure des tranchées, pour former les cloisons intermédiaires, puis dépôt standard de métal au centre des tranchées ; ou

5'/ remplissage des tranchées par dépôt standard de métal.

Le procédé peut ensuite comprendre une étape de réalisation des microlentilles, par exemple à l'aide d'un masque de résine. Une première structure ainsi formée est ensuite reportée par collage sur une seconde structure comportant l'étage de photo-détection muni du revêtement antireflet. Le substrat initial en silicium est ensuite retiré, par exemple par une découpe dite « fly-cutting ». Des variantes de ce procédé peuvent être mises en oeuvre. Cependant, le procédé de fabrication met forcément en oeuvre une étape de report par collage, sur un détecteur infrarouge hybridé (l'étage de photo-détection).

## Revendications

1. Dispositif (100; 200; 300 ; 400 ; 500 ; 600) de photo-détection multi-spectrale dans l'infrarouge, qui comporte un étage de photo-détection (140; 540) et un étage de filtrage (110 ; 210 ; 510), superposés l'un au-dessus de l'autre le long d'un axe nommé axe optique, dans lequel :

   - l'étage de photo-détection (140 ; 540) comporte un circuit de lecture (143), une couche active (141 ; 241) en matériau semi-conducteur, incorporant une matrice de photodiodes (1410 ; 6410), et un substrat de support (142), superposés dans cet ordre le long de l'axe optique, et avec le circuit de lecture (143) connecté électriquement aux photodiodes (1410 ; 6410) de la matrice de photodiodes ;
   - l'étage de filtrage (110 ; 210 ; 510) comprend une matrice de zones de filtrage qui est constituée de zone de filtrage d'au moins deux types, parmi lesquelles des zones de filtrage d'un premier type (1102; 3102; 4102; 5102 ; 6102), formées chacune d'un filtre interférentiel et aptes chacune à transmettre les longueurs d'onde d'une première bande spectrale et à bloquer les longueurs d'onde d'une deuxième bande spectrale, et des zones de filtrage d'un deuxième type (1103 ; 3103 ; 4103 ; 5103 ; 6103), aptes chacune à transmettre une partie au moins des longueurs d'onde de la deuxième bande spectrale ;

   **caractérisé en ce qu'**il comporte en outre :

   - une couche de colle (120 ; 220), qui s'étend entre l'étage de photo-détection (140 ; 540) et l'étage de filtrage (110 ; 210 ; 510), avec, dans l'étage de photo-détection, le substrat de support (142) situé du côté de la couche de colle ; et
   - un revêtement antireflet (130 ; 230), qui s'étend entre la couche de colle (120 ; 220) et le substrat de support (142), et qui est configuré pour réduire des réflexions internes dans l'infrarouge.

2. Dispositif (100 ; 200 ; 300 ; 400 ; 500 ; 600) selon la revendication 1, **caractérisé en ce qu'**une topologie de surface du substrat de support (142) présente une amplitude pic-vallée ($A_{PV}$) supérieure ou égale à 3 $\mu$m à 300 K, du côté de la couche de colle (120 ; 220), et **en ce qu'**une topologie de surface de l'étage de filtrage (110 ; 210 ; 510) présente une topologie de surface avec une amplitude pic-vallée inférieure ou égale à 300 nm à 300 K, du côté de la couche de colle (20 ; 220), une différence entre ces deux topologies de surface étant compensée par des variations d'épaisseur de la couche de colle (120 ; 220).

3. Dispositif (200 ; 300 ; 400 ; 500 ; 600) selon la revendication 1 ou 2, **caractérisé en ce qu'**il comporte en outre une matrice de microlentilles (250), qui s'étend entre la couche de colle (220) et l'étage de filtrage (210 ; 510).

4. Dispositif (600) selon l'une quelconque des revendications 1 à 3, **caractérisé en ce que** dans au moins une direction de l'espace, un pas de répartition (P1) des microlentilles (651) de la matrice de microlentilles est un multiple d'un pas de répartition (P2) des photodiodes (6410) de la matrice de photodiodes.

5. Dispositif (300 ; 400 ; 500 ; 600) selon l'une quelconque des revendications 1 à 4, **caractérisé en ce qu'**il comporte en outre des murs métalliques (360 ; 460), qui s'étendent dans la couche de filtrage, entre des zones de filtrage voisines (3102, 3103 ; 4102, 4103 ; 5102, 5103 ; 6102, 6103).

6. Dispositif (300 ; 400 ; 500 ; 600) selon la revendication 5, **caractérisé en ce que** les murs métalliques (360 ; 460) s'étendent ensemble selon une grille, avec dans chaque ouverture de la grille au moins une zone de filtrage (3102 ; 3103; 4102; 4103 ; 5102 ; 5103 ; 6102 ; 6103) de la matrice de zones de filtrage.

7. Dispositif (300 ; 400 ; 500 ; 600) selon la revendication 6, **caractérisé en ce que** chaque ouverture de la grille comporte une et unique zone de filtrage (3102 ; 3103 ; 4102 ; 4103 ; 5102 ; 5103 ; 6102 ; 6103) de la matrice de zones de filtrage.

8. Dispositif (400 ; 500 ; 600) selon l'une quelconque des revendications 5 à 7, **caractérisé en ce qu'**une partie au moins de l'un au moins des murs métalliques (460), est encadrée par deux cloisons intermédiaires (470) en matériau diélectrique.

9. Dispositif (400 ; 500 ; 600) selon la revendication 8, **caractérisé en ce qu'**une épaisseur (hd) des cloisons intermédiaires (470), définie dans un plan orthogonal à l'axe optique, est comprise entre 500 nm et 50 nm.

10. Dispositif (100 ; 200 ; 300 ; 400 ; 500 ; 600) selon l'une quelconque des revendications 1 à 9, **caractérisé en ce que** chaque zone de filtrage du premier type (1102 ; 3102 ; 4102 ; 5102 ; 6102) est constituée par un empilement de couches chacune en matériau diélectrique.

11. Dispositif (100 ; 200 ; 300 ; 400 ; 600) selon la revendication 10, **caractérisé en ce que** chaque zone de filtrage du deuxième type (1103 ; 3103 ; 4103 ; 6103) est apte à transmettre les longueurs d'onde de la deuxième bande spectrale et les longueurs d'onde de la première bande spectrale, et constituée d'un matériau diélectrique nommé matériau de remplissage.

12. Dispositif (500) selon la revendication 10, **caractérisé en ce que** chaque zone de filtrage du deuxième type (5103) est apte à transmettre les longueurs d'onde de la deuxième bande spectrale et à bloquer les longueurs d'onde de la deuxième bande spectrale, et constituée par un filtre interférentiel respectif.

13. Dispositif (100 ; 200 ; 300 ; 400 ; 500 ; 600) selon l'une quelconque des revendications 1 à 12, **caractérisé en ce que** la couche active (141; 241) est en alliage de cadmium, mercure et tellure.

14. Système comportant un dispositif (100 ; 200 ; 300 ; 400 ; 500 ; 600) selon l'une quelconque des revendications 1 à 13, et un refroidisseur cryogénique couplé thermiquement au dispositif selon l'invention, et apte à refroidir ledit dispositif jusqu'à des températures inférieures ou égales à 200 K.

**Patentansprüche**

1. Vorrichtung (100; 200; 300; 400; 500; 600) zur multispektralen Fotodetektion im Infrarotbereich, die eine Fotodetektionsstufe (140; 540) und eine Filterstufe (110; 210; 510) umfasst, die entlang einer Achse, als optische Achse bezeichnet, übereinander angeordnet sind, wobei:

   - die Fotodetektionsstufe (140; 540) eine Leseschaltung (143), eine aktive Schicht (141; 241) aus einem Halbleitermaterial, die eine Matrix aus Fotodioden (1410; 6410) enthält, und ein Trägersubstrat (142) umfasst, die in dieser Reihenfolge entlang der optischen Achse übereinander angeordnet sind, wobei die Leseschaltung (143) elektrisch mit den Fotodioden (1410; 6410) der Matrix aus Fotodioden verbunden ist;
   - die Filterstufe (110; 210; 510) eine Matrix aus Filterbereichen umfasst, die aus Filterbereichen von mindestens zwei Typen hergestellt ist, darunter Filterbereiche eines ersten Typs (1102; 3102; 4102; 5102; 6102), die jeweils aus einem Interferenzfilter gebildet sind und jeweils dazu ausgelegt sind, die Wellenlängen eines ersten Spektralbands zu übertragen und die Wellenlängen eines zweiten Spektralbands zu blockieren, und Filterbereiche eines zweiten Typs (1103; 3103; 4103; 5103; 6103), die jeweils dazu ausgelegt sind, mindestens einen Teil der Wellenlängen des zweiten Spektralbandes zu übertragen;

   **dadurch gekennzeichnet, dass** sie ferner Folgendes umfasst:

   - eine Klebeschicht (120; 220), die sich zwischen der Fotodetektionsstufe (140; 540) und der Filterstufe (110;

210; 510) erstreckt, wobei sich in der Fotodetektionsstufe das Trägersubstrat (142) auf einer Seite der Klebeschicht befindet; und
- eine Antireflexionsbeschichtung (130; 230), die sich zwischen der Klebeschicht (120; 220) und dem Trägersubstrat (142) erstreckt und dazu konfiguriert ist, innere Reflexionen im Infrarotbereich zu reduzieren.

2. Vorrichtung (100; 200; 300; 400; 500; 600) nach Anspruch 1, **dadurch gekennzeichnet, dass** eine Oberflächentopologie des Trägersubstrats (142) eine Spitze-Tal-Amplitude ($A_{PV}$) von größer oder gleich 3 $\mu$m bei 300 K auf der Seite der Klebeschicht (120; 220) aufweist, und dass eine Oberflächentopologie der Filterstufe (110; 210; 510) eine Oberflächentopologie mit einer Spitze-Tal-Amplitude von kleiner oder gleich 300 nm bei 300 K auf der Seite der Klebeschicht (20; 220) aufweist, wobei ein Unterschied zwischen den beiden Oberflächentopologien durch Variationen in der Dicke der Klebeschicht (120; 220) ausgeglichen wird.

3. Vorrichtung (200; 300; 400; 500; 600) nach Anspruch 1 oder 2, **dadurch gekennzeichnet, dass** sie ferner eine Matrix aus Mikrolinsen (250) umfasst, die sich zwischen der Klebeschicht (220) und der Filterstufe (210; 510) erstreckt.

4. Vorrichtung (600) nach einem der Ansprüche 1 bis 3, **dadurch gekennzeichnet, dass** in mindestens eine Raumrichtung ein Aufteilungsschritt (P1) der Mikrolinsen (651) der Matrix aus Mikrolinsen ein Vielfaches eines Aufteilungsschritts (P2) der Fotodioden (6410) der Matrix aus Fotodioden ist.

5. Vorrichtung (300; 400; 500; 600) nach einem der Ansprüche 1 bis 4, **dadurch gekennzeichnet, dass** sie ferner Metallwände (360; 460) umfasst, die sich zwischen benachbarten Filterbereichen (3102, 3103, 4102, 4103; 5102, 5103; 6102, 6103) in die Filterstufe hinein erstrecken.

6. Vorrichtung (300; 400; 500; 600) nach Anspruch 5, **dadurch gekennzeichnet, dass** sich die Metallwände (360; 460) gemäß einem Gitter zusammen erstrecken, wobei jede Öffnung des Gitters mindestens einen Filterbereich (3102, 3103, 4102, 4103; 5102, 5103; 6102, 6103) der Matrix aus Filterbereichen umfasst.

7. Vorrichtung (300; 400; 500; 600) nach Anspruch 6, **dadurch gekennzeichnet, dass** jede Öffnung des Gitters einen eindeutigen Filterbereich (3102, 3103; 4102, 4103; 5102, 5103; 6102, 6103) der Matrix aus Filterbereichen umfasst.

8. Vorrichtung (400; 500; 600) nach einem der Ansprüche 5 bis 7, **dadurch gekennzeichnet, dass** mindestens ein Teil der mindestens einen der Metallwände (460) durch zwei Zwischentrennwände (470) aus dielektrischem Material eingefasst ist.

9. Vorrichtung (400; 500; 600) nach Anspruch 8, **dadurch gekennzeichnet, dass** eine Dicke (hd) der Zwischentrennwände (470), die in einer Ebene orthogonal zur optischen Achse definiert ist, zwischen 500 nm und 50 nm beträgt.

10. Vorrichtung (100; 200; 300; 400; 500; 600) nach einem der Ansprüche 1 bis 9, **dadurch gekennzeichnet, dass** jeder Filterbereich des ersten Typs (1102; 3102; 4102; 5102; 6102) aus einem Stapel von Schichten hergestellt ist, die jeweils aus einem dielektrischen Material bestehen.

11. Vorrichtung (100; 200; 300; 400; 600) nach Anspruch 10, **dadurch gekennzeichnet, dass** jeder Filterbereich des zweiten Typs (1103; 3103; 4103; 6103) dazu ausgelegt ist, die Wellenlängen des zweiten Spektralbandes und die Wellenlängen des ersten Spektralbandes zu übertragen, und aus einem dielektrischen Material, als Füllmaterial bezeichnet, hergestellt ist.

12. Vorrichtung (500) nach Anspruch 10, **dadurch gekennzeichnet, dass** jeder Filterbereich des zweiten Typs (5103) dazu ausgelegt ist, die Wellenlängen des zweiten Spektralbandes zu übertragen und die Wellenlängen des zweiten Spektralbandes zu blockieren, und aus einem jeweiligen Interferenzfilter hergestellt ist.

13. Vorrichtung (100; 200; 300; 400; 500; 600) nach einem der Ansprüche 1 bis 12, **dadurch gekennzeichnet, dass** die aktive Schicht (141; 241) aus einer Legierung aus Cadmium, Quecksilber und Tellur besteht.

14. System, das eine Vorrichtung (100; 200; 300; 400; 500; 600) nach einem der Ansprüche 1 bis 13 und eine kryogene Kühleinrichtung umfasst, die thermisch mit der erfindungsgemäßen Vorrichtung gekoppelt und dazu ausgelegt ist, die Vorrichtung bis auf Temperaturen von kleiner oder gleich 200 K herunterzukühlen.

**Claims**

1. A device (100; 200; 300; 400; 500; 600) for multi-spectral photo-detection in the infrared, which includes a photo-detection stage (140; 540) and a filtering stage (110; 210; 510), superimposed on top of one another along an axis called the optical axis, wherein:

   - the photo-detection stage (140; 540) includes a read circuit (143), an active layer (141; 241) made of a semiconductor material, incorporating a matrix of photodiodes (1410; 6410), and a support substrate (142), superimposed in that order along the optical axis, and with the read circuit (143) electrically connected to the photodiodes (1410; 6410) of the photodiode matrix;
   - the filtering stage (110; 210; 510) comprises a matrix of filtering areas which consists of filtering areas of at least two types, among which filtering areas of a first type (1102; 3102; 4102; 5102; 6102), each formed of an interference filter and each capable of transmitting the wavelengths of a first spectral band and of blocking the wavelengths of a second spectral band, and filtering areas of a second type (1103; 3103; 4103; 5103; 6103), each capable of transmitting at least part of the wavelengths of the second spectral band; **characterised in that** it further includes:

      - an adhesive layer (120; 220), which extends between the photo-detection stage (140; 540) and the filtering stage (110; 210; 510), with, in the photo-detection stage, the support substrate (142) located on the adhesive layer side; and
      - an anti-reflective coating (130; 230), which extends between the adhesive layer (120; 220) and the support substrate (142), and which is configured to reduce inner reflections in the infrared.

2. The device (100; 200; 300; 400; 500; 600) according to claim 1, **characterised in that** a surface topology of the support substrate (142) has a peak-valley amplitude ($A_{PV}$) greater than or equal to 3 $\mu$m at 300 K, on the adhesive layer side (120; 220), and **in that** a surface topology of the filtering stage (110; 210; 510) has a surface topology with a peak-valley amplitude less than or equal to 300 nm at 300 K, on the adhesive layer side (20; 220), a difference between these two surface topologies being compensated by variations in the thickness of the adhesive layer (120; 220).

3. The device (200; 300; 400; 500; 600) according to claim 1 or 2, **characterised in that** it further includes a matrix of microlenses (250), which extends between the adhesive layer (220) and the filtering stage (210; 510).

4. The device (600) according to any one of claims 1 to 3, **characterised in that** in at least one direction in space, a distribution step (P1) of the microlenses (651) of the microlens matrix is a multiple of a distribution step (P2) of the photodiodes (6410) of the photodiode matrix.

5. The device (300; 400; 500; 600) according to any one of claims 1 to 4, **characterised in that** it further includes metal walls (360; 460), which extend into the filtering layer, between neighbouring filtering areas (3102, 3103; 4102, 4103; 5102, 5103; 6102, 6103).

6. The device (300; 400; 500; 600) according to claim 5, **characterised in that** the metal walls (360; 460) extend together according to a grid, with in each opening of the grid at least one filtering area (3102; 3103; 4102; 4103; 5102; 5103; 6102; 6103) of the filtering area matrix.

7. The device (300; 400; 500; 600) according to claim 6, **characterised in that** each opening of the grid includes a unique filtering area (3102; 3103; 4102; 4103; 5102; 5103; 6102; 6103) of the filtering area matrix.

8. The device (400; 500; 600) according to any one of claims 5 to 7, **characterised in that** at least one portion of at least one of the metal walls (460) is bordered by two intermediate partitions (470) made of a dielectric material.

9. The device (400; 500; 600) according to claim 8, **characterised in that** a thickness (hd) of the intermediate partitions (470), defined in a plane orthogonal to the optical axis, is comprised between 500 nm and 50 nm.

10. The device (100; 200; 300; 400; 500; 600) according to any one of claims 1 to 9, **characterised in that** each filtering area of the first type (1102; 3102; 4102; 5102; 6102) consists of a stack of layers each made of a dielectric material.

11. The device (100; 200; 300; 400; 600) according to claim 10, **characterised in that** each filtering area of the second type (1103; 3103; 4103; 6103) is capable of transmitting the wavelengths of the second spectral band and the wavelengths of the first spectral band, and consists of a dielectric material called filler material.

12. The device (500) according to claim 10, **characterised in that** each filtering area of the second type (5103) is capable of transmitting the wavelengths of the second spectral band and of blocking the wavelengths of the second spectral band, and consists of a respective interference filter.

13. The device (100; 200; 300; 400; 500; 600) according to any one of claims 1 to 12, **characterised in that** the active layer (141; 241) is made of an alloy of cadmium, mercury and tellurium.

14. A system including a device (100; 200; 300; 400; 500; 600) according to any one of claims 1 to 13, and a cryogenic cooler thermally coupled to the device according to the invention, and capable of cooling said device down to temperatures lower than or equal to 200 K.

FIG.1

FIG.2

FIG.3A

FIG.3B

FIG.4A

FIG.4B

FIG.5

FIG.6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 9972727 B2